# FASCICULE DE BREVET EUROPEEN

(11) **EP 0 413 645 B1**
(45) Date de publication et mention de la délivrance du brevet: **12.07.1995**
(21) Numéro de dépôt: 90420374.2
(22) Date de dépôt: 09.08.1990
(51) Int. Cl.: H01L 21/336, H01L 21/84, H01L 29/772

(54) **Procédé de fabrication de transistor MOS mésa de type silicium sur isolant**
Verfahren zum Herstellen eines Mesa-MOS-Transistors des Typs SOI
Method of producing a mesa MOS transistor of the silicon on insulator type

(30) Priorité: 16.08.1989 FR 8911228
(43) Date de publication de la demande: 20.02.1991
(73) Titulaire: FRANCE TELECOM, 75015 Paris (FR)
(72) Inventeur: Haond, Michel, F-38240 Meylan (FR); Galvier, Jean, F-38400 Saint Martin D' Hères (FR)
(74) Mandataire: de Beaumont, Michel

(56) Documents cités:
- US-A- 4 753 896

## Description

La présente invention concerne les transistors MOS fabriqués à partir d'une couche mince de silicium monocristallin sur isolant et plus particulièrement les transistors de type mésa, c'est-à-dire les transistors formés à partir de pavés individuels découpés dans la couche mince de silicium.

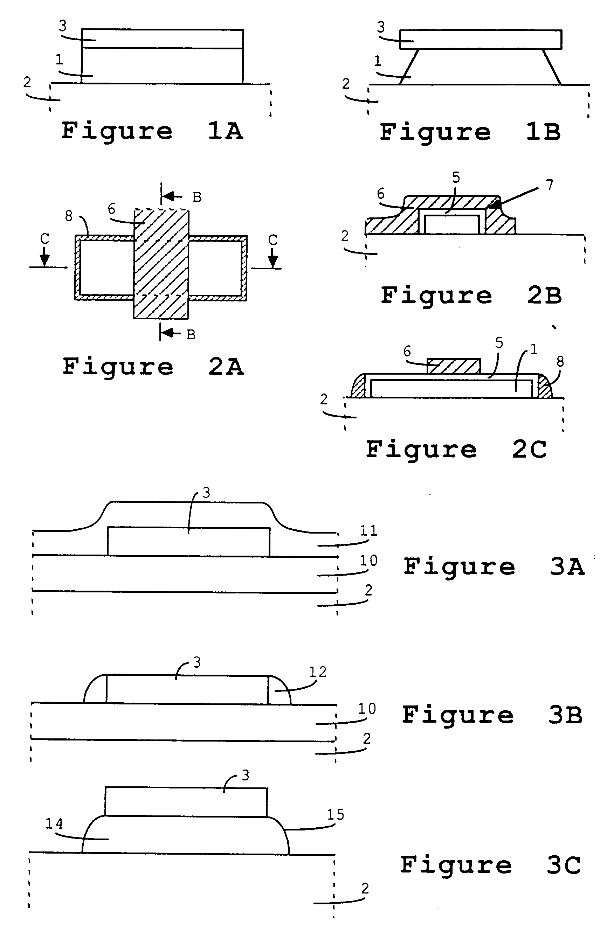

La figure 1A représente un tel pavé de silicium. Ce pavé 1 est formé sur un substrat isolant 2 et l'on a représenté au-dessus du pavé de silicium 1 la portion de couche de masquage 3 qui a servi à le délimiter. Couramment, l'isolant 2 est constitué d'une couche d'oxyde de silicium formée sur une tranche de silicium et la couche de masquage 3 est constituée d'un sandwich d'oxyde de silicium et de nitrure de silicium ou d'oxyde-nitrure-oxyde de silicium (ONO). Dans la représentation de la figure 1A, on a présupposé que le pavé de silicium 1 avait été délimité par une gravure anisotrope (par exemple en présence d'un plasma fluoré) d'où il résulte que chaque pavé présente des flancs rectilignes et que le pavé a une forme parallélépipédique. Un tel procédé de fabrication est connu du brevet US-A-4 753 896.

La figure 1B représente une structure analogue à celle de la figure 1A mais dans laquelle la gravure a été réalisée par un procédé de gravure humide par un acide tel que de l'hydroxyde de potassium (KOH).

On préfère généralement utiliser le procédé de la figure 1A car en ce cas la cote du pavé de silicium 1 correspond avec une grande précision à la cote de masquage 3 alors que, dans le cas d'une gravure isotrope, il se présente une perte de cote et les dimensions du pavé ne sont pas nettement déterminées. En outre l'utilisation de KOH présente des inconvénients liés à la présence éventuelle de résidus de potassium. Mais, dans le cas de la gravure anisotrope, l'angle entre la surface supérieure d'un pavé et le départ des flancs est sensiblement droit.

La figure 2A représente une vue de dessus d'un transistor MOS obtenu à partir d'un pavé à flancs droits à une étape intermédiaire de fabrication, et les figures 2B et 2C représentent des vues en coupe selon les plans BB et CC, respectivement, de la figure 2A. Ces figures considèrent une étape de fabrication dans laquelle la couche de masquage 3 a été éliminée, une couche mince d'oxyde de grille 5 a été déposée, et une couche de silicium polycristallin de grille 6 a été déposée puis gravée selon la forme de grille souhaitée. Après cette étape, de façon classique, on procèdera à un premier dopage de drain et de source, à la formation d'espaceurs de part et d'autre de la grille, à une seconde implantation de drain et de source et à la réalisation de contacts.

Une telle réalisation souffre de divers inconvénients.

D'abord, si l'on considère comme cela est visible en figure 2B la couche l'oxyde de grille 5, celle-ci présentera inévitablement des défaillances au niveau des coins droits 7, d'où il résulte des points à faible tenue de claquage aux angles supérieurs des mésas.

Un deuxième inconvénient est que, quand on grave la grille de silicium polycristallin 6, ceci est effectué par gravure anisotrope pour conserver la cote du masque ayant servi à définir la grille. Il en résulte qu'il demeure des résidus 8 visibles en figure 2A et 2C à la périphérie du pavé. Ces résidus sont susceptibles de provoquer des courts-circuits et pour les éliminer on est amené à surgraver la grille et les dimensions de masque ne sont plus respectées ce qui constitue un inconvénient rédhibitoire dans le cas où l'on atteint des dimensions inférieures au micromètre.

Troisièmement, quand on réalise un transistor MOS, on souhaite généralement surdoper (selon le type de dopage inverse de celui des drains-sources) la périphérie du pavé pour supprimer tout effet de transistor parasite le long des bords du transistor. Un tel surdopage par implantation ne peut être effectué à partir d'un pavé à flancs raides tel que celui illustré en figure 1A. On est donc amené à mettre en oeuvre des techniques plus compliquées, consistant, après formation des plots de masquage 3 et avant gravure des pavés 1, à implanter la tranche de silicium puis à effectuer un recuit pour obtenir une pénétration latérale dans les flancs du pavé. Après gravure on obtient bien des pavés à flancs surdopés. Cette technique présente l'inconvénient de rajouter de nombreuses étapes de fabrication et d'être relativement imprécise.

Tous les inconvénients susmentionnés des transistors de l'art antérieur proviennent du choix de pavés à flancs raides.

Ainsi, la présente invention prévoit de fabriquer des transistors MOS formés dans des pavés de silicium gravés dans une couche mince de silicium sur isolant dans lesquels chaque pavé présente des flancs arrondis convexes.

La présente invention prévoit un procédé de fabrication d'un tel transistor MOS consistant initialement à découper un pavé de silicium dans une couche mince de silicium monocristallin sur isolant, la découpe du pavé comprenant les étapes suivantes :
- former à l'emplacement où l'on veut obtenir le pavé une portion de couche de masquage d'une épaisseur légèrement supérieure à celle de la couche mince de silicium sur isolant ;
- déposer sur l'ensemble de la surface exposée une deuxième couche de silicium d'une épaisseur prédéterminée ; et
- soumettre le système à une gravure anisotrope jusqu'à ce que ledit isolant soit apparent en dehors de la portion de couche de masquage.

Selon un mode de réalisation de la présente invention, le masque est constitué d'un sandwich oxyde de silicium/nitrure de silicium/oxyde de silicium. On peut alors prévoir l'étape consistant à réaliser une implantation dans le pavé de silicium tandis qu'il est encore masqué, pour surdoper ses flancs.

Selon un autre mode de réalisation de la présente invention, le masque est constitué d'un sandwich oxyde de silicium/silicium/oxyde de silicium. L'étape de gravure anisotrope peut alors être subdivisée en les étapes suivantes : graver le silicium jusqu'à ce que la couche supérieure du masque soit apparente ; graver l'oxyde de silicium supérieur du masque ; et graver le silicium jusqu'à ce que ledit isolant soit apparent en dehors de la portion de couche de masquage.

On montrera dans la description détaillée ci-après comment la structure selon la présente invention permet d'éviter tous les inconvénients susmentionnés de l'art antérieur.

Ces objets, caractéristiques et avantages ainsi que d'autres de la présente invention seront exposés plus en détail dans la description suivante de modes de réalisation particuliers faite en relation avec les figures jointes parmi lesquelles :
les figures 1A à 2C destinées à illustrer l'état de la technique et le problème posé ont été décrites précédemment ;
les figures 3A à 3C représentent des étapes successives de fabrication d'un pavé de transistor MOS selon la présente invention.

On notera dans les diverses figures que les épaisseurs et dimensions latérales des diverses couches ou portions de couches ne sont pas tracées à l'échelle ni à l'intérieur d'une figure donnée ni d'une figure à l'autre. Ces dimensions, comme cela est classique dans le domaine de la représentation des circuits intégrés ont été arbitrairement dilatées pour améliorer la lisibilité des figures.

La figure 3A représente une vue en coupe d'une tranche comprenant un substrat isolant 2, par exemple une plaquette de silicium dont la surface supérieure est oxydée, sur laquelle a été formée une couche mince de silicium monocristallin 10. Au dessus de cette couche, apparaît une portion de couche de masquage 3 à un emplacement où l'on veut former un pavé de silicium monocristallin.

Selon l'invention, l'ensemble de la structure est revêtu d'une couche de silicium 11, qui sera couramment du silicium polycristallin ou du silicium amorphe déposé par voie chimique en phase vapeur (CVD). La couche de masquage 3 sera par exemple constituée d'un sandwich comprenant une couche mince d'oxyde de silicium, une couche de nitrure de silicium et une couche plus épaisse d'oxyde de silicium (ONO).

On procède ensuite à une gravure anisotrope du silicium, par exemple en présence d'un plasma de SF₆ ou d'un plasma chloré tels qu'on les utilise pour la formation d'espaceurs en silicium polycristallin dans les technologies CMOS utilisant des drains étendus sous la grille (LDD). La figure 3B représente un stade intermédiaire de la gravure, dans lequel la couche de silicium polycristallin a été complètement éliminée dans ses parties planes mais demeure sur les bords de la portion de couche de masquage 3, là où elle était plus épaisse. Ainsi, quand la gravure se poursuit jusqu'à ce que l'on atteigne le substrat isolant 2, comme le représente la figure 3C, on obtient un pavé de silicium 14 présentant des flancs arrondis convexes 15 en débordement par rapport à la région de couche de masquage 3. Pour que le motif des espaceurs soit reproduit sur les flancs du pavé sans apparition de marche, il convient que l'épaisseur de la couche mince soit égale ou légèrement supérieure à celle de la couche mince de silicium 10. L'épaisseur de la couche de silicium 11 déterminera l'étendue latérale des espaceurs.

On peut ainsi résoudre tous les inconvénients mentionnés de l'art antérieur. Plus particulièrement :
- il est facile de procéder à une implantation qui atteindra seulement les parties en débordement du pavé 14 et permettra ainsi de réaliser un surdopage à un niveau précisément choisi des bords du pavé ;
- du fait du profil arrondi des pavés 14, la couche d'oxyde mince de grille 5 que l'on déposera ensuite ne présentera pas d'irrégularités ;
- toujours du fait de cet aspect arrondi des bords du pavé, quand on déposera un silicium polycristallin de grille, celui-ci ne présentera pas de surépaisseur et se déposera de façon sensiblement conforme au profil du substrat isolant 2 et du pavé 14 et pourra donc être gravé de façon anisotrope sans laisser de résidus.

Dans un premier exemple de mise en oeuvre de l'invention, dans le cas d'une couche mince de silicium sur isolant 10 d'une épaisseur de 150 nm, on pourra utiliser un masque 3 comprenant des couches successives de SiO₂, Si₃N₄ et SiO₂ d'épaisseurs respectives 15 nm, 125 nm et 30 nm. La couche de silicium polycristallin 11 pourra avoir une épaisseur de 300 nm. En ce cas, à la fin du processus de formation du pavé 14, comme cela est représenté en figure 3C, le masque 3 est toujours en place. Ceci présente un avantage pour l'implantation latérale du pavé mais présente un inconvénient car il faut ensuite éliminer ce masque, opération qui peut être quelque peu traumatisante pour la structure.

Dans un deuxième exemple de mise en oeuvre de l'invention, dans le masque 3, la couche de nitrure est remplacée par une couche de silicium polycristallin. Dans ce cas, on arrêtera la gravure du silicium 11 au stade illustré en figure 3B, on éliminera la couche d'oxyde supérieure du masque et on continuera la gravure de la couche de silicium 10 et des espaceurs 12 tandis que, simultanément, la couche de silicium du masque s'éliminera pour ne laisser en place que la couche d'oxyde de silicium inférieure du masque. Ceci présente l'avantage que le reste du masque (la couche d'oxyde) est alors très facile à éliminer, mais il faut alors procéder initialement à l'implantation latérale, immédiatement après formation du masque 3.

Les exemples ci-dessus ont été donnée à titre illustratif seulement des nombreuses possibilités et variantes que la présente invention offre à l'homme de l'art qui pourra selon son expérience choisir divers matériaux et dimensionnements.

## Revendications

1. Procédé de fabrication d'un transistor MOS formé dans un pavé de silicium monocristallin (14) sur isolant (2) dans lequel ledit pavé présente des flancs arrondis convexes (15), consistant à découper la pavé dans une couche mince de silicium monocristallin (10) sur isolant (2) et en formant à l'emplacement où l'on veut obtenir le pavé une portion de couche de masquage (3) d'une épaisseur légèrement supérieure à celle de la couche mince de silicium monocristallin (10), caractérisé en ce que la découpe du pavé comprend les étapes suivantes :
- déposer sur l'ensemble de la surface exposée une deuxième couche de silicium (11) d'une épaisseur prédéterminée ; et
- soumettre le système à une gravure anisotrope jusqu'à ce que ledit isolant (2) soit apparent en dehors de la portion de couche de masquage.

2. Procédé selon la revendication 1, caractérisé en ce que l'isolant sur lequel est formée la couche mince de silicium monocristallin est constitué d'une couche d'oxyde de silicium formée sur une plaquette de silicium.

3. Procédé selon la revendication 1, caractérisé en ce que le masque est constitué d'un sandwich oxyde de silicium/nitrure de silicium/oxyde de silicium.

4. Procédé selon la revendication 1, caractérisé en ce que le masque est constitué d'un sandwich oxyde de silicium/silicium.

5. Procédé selon la revendication 3, caractérisé en ce qu'il comprend en outre l'étape consistant à réaliser une implantation dans le pavé de silicium tandis qu'il est encore masqué, pour surdoper ses flancs.

6. Procédé selon la revendication 1, caractérisé en ce que le masque est constitué d'un sandwich oxyde de silicium/silicium/oxyde de silicium.

7. Procédé selon la revendication 6, caractérisé en ce qu'il comprend en outre l'étape consistant à réaliser une implantation après formation de la portion de couche de masquage (3).

8. Procédé selon la revendication 5, caractérisé en ce que l'étape de gravure anisotrope selon la revendication 1 se subdivise en les étapes suivantes :
- graver le silicium jusqu'à ce que la couche supérieure du masque soit apparente ;
- graver l'oxyde de silicium supérieur du masque ;
- graver le silicium jusqu'à ce que ledit isolant soit apparent en dehors de la portion de couche de masquage.

## Patentansprüche

1. Verfahren zur Herstellung eines in einem Block aus monokristallinem Silicium (14) auf einem Isolator (2) ausgebildeten MOS-Transistors, bei dem der Block konvex gerundete Flanken (15) aufweist, welches darin besteht, den Block aus einer dünnen Schicht aus monokristallinem Silicium (10) auf einem Isolator (2) auszuschneiden und an dem Ort, wo man den Block erhalten will, einen Maskenschicht-Abschnitt (3) mit einer geringfügig größeren Dicke als derjenigen der dünnen Schicht aus monokristallinem Silicium (10) auszubilden, dadurch gekennzeichnet, daß das Ausschneiden des Blocks die folgenden Schritte umfaßt:
- Abscheiden einer zweiten Siliciumschicht (11) mit einer vorbestimmten Dicke über der gesamten freiliegenden Oberfläche und
- Unterziehen des Systems unter eine anisotrope Ätzung, bis der Isolator (2) außerhalb des Maskenschicht-Abschnitts erscheint.

2. Verfahren nach Anspruch 1, dadurch gekennzeichnet, daß der Isolator, auf dem die dünne Schicht aus monokristallinem Silicium ausgebildet ist, aus einer Siliciumoxidschicht besteht, die auf einem Siliciumwafer ausgebildet ist.

3. Verfahren nach Anspruch 1, dadurch gekennzeichnet, daß die Maske aus einer Siliciumoxid/Siliciumnitrid/Siliciumoxid-Schichtstruktur besteht.

4. Verfahren nach Anspruch 1, dadurch gekennzeichnet, daß die Maske aus einer Siliciumoxid/Silicium-Schichtstruktur besteht.

5. Verfahren nach Anspruch 3, dadurch gekennzeichnet, daß es weiterhin einen Schritt umfaßt, welcher darin besteht, eine Implantation in dem Siliciumblock zu realisieren, während er noch maskiert ist, um seine Flanken überzudotieren.

6. Verfahren nach Anspruch 1, dadurch gekennzeichnet, daß die Maske aus einer Siliciumoxid/Silicium/Siliciumoxid-Schichtstruktur besteht.

7. Verfahren nach Anspruch 6, dadurch gekennzeichnet, daß es weiterhin einen Schritt umfaßt, der darin besteht, eine Implantation nach der Bildung des Maskenschicht-Abschnitts (3) zu realisieren.

8. Verfahren nach Anspruch 5, dadurch gekennzeichnet, daß der Schritt des anisotropen Ätzens nach Anspruch 1 sich in die folgenden Schritte unterteilt:
- Ätzen des Siliciums, bis die obere Schicht der Maske erscheint,
- Ätzen des oberen Siliciumoxids der Maske,
- Ätzen des Siliciums, bis der Isolator außerhalb des Maskenschicht-Abschnitts erscheint.

## Claims

1. A method for manufacturing a MOS transistor in a block of single-crystal silicon (14) on an insulator (2), wherein said block has convex rounded up edges (15), consisting in cutting the block in a thin layer of single-crystal silicon (10) on insulator (2), and in forming at the position where it is desired to obtain the block a mask layer portion (3) having a thickness slightly larger than that of the thin single-crystal silicon layer (10), characterized in that the block cutting comprises the following steps;
- depositing on the whole exposed surface a second silicon layer (11) having a predetermined thickness; and
- anisotropically etching silicon until said insulator (2) is apparent outside said mask portion.

2. A method according to claim 1, characterized in that the insulator on which is formed said thin single-crystal silicon layer is constituted by a silicon oxide layer formed on a silicon wafer.

3. A method according to claim 1, characterized in that said mask is constituted by a silicon oxide/silicon nitride/silicon oxide sandwich.

4. A method according to claim 1, characterized in that said mask is constituted by a silicon oxide/silicon sandwich.

5. A method according to claim 3, characterized in that it further comprises the step consisting in implanting a dopant in the silicon block while it is still masked, in order to overdop its edges.

6. A method according to claim 1, characterized in that the mask is constituted by a silicon oxide/silicon/silicon oxide sandwich.

7. A method according to claim 6, characterized in that it further comprises the step consisting in implanting a dopant after formation of said mask layer portion (3).

8. A method according to claim 5, characterized in that the anisotropic etching step according to claim 1 is subdivided into the following steps:
- etching the silicon until the upper layer of the mask is apparent;
- etching the upper silicon layer of the mask; and
- etching the silicon until said insulator is apparent outside the mask layer portion.
